# EUROPÄISCHE PATENTSCHRIFT

(11) **EP 3 794 310 B1**
(45) Veröffentlichungstag und Bekanntmachung des Hinweises auf die Patenterteilung: **04.10.2023**
(21) Anmeldenummer: 18727735.5
(22) Anmeldetag: 17.05.2018
(51) Int. Cl.: G01B 21/04

(54) **VERFAHREN UND VORRICHTUNG ZUR ERZEUGUNG EINES PRÜFPLANS, VERFAHREN UND VORRICHTUNG ZUR PRÜFUNG EINES MESSOBJEKTS UND COMPUTERPROGRAMMPRODUKT**
METHOD AND DEVICE FOR GENERATING A TEST PLAN, METHOD AND DEVICE FOR TESTING AN OBJECT TO BE MEASURED AND COMPUTER PROGRAM PRODUCT
PROCÉDÉ ET DISPOSITIF POUR PRODUIRE UN PLAN DE CONTRÔLE, PROCÉDÉ ET DISPOSITIF POUR CONTRÔLER UN OBJET À MESURER ET PRODUIT-PROGRAMME INFORMATIQUE

(43) Veröffentlichungstag der Anmeldung: 24.03.2021
(73) Patentinhaber: Carl Zeiss Industrielle Messtechnik GmbH, 73447 Oberkochen (DE)
(72) Erfinder: MAYR ADAM, Ana Carolina, 73430 Aalen (DE); RIEGER, Stephan, 73447 Oberkochen (DE); MAYER, Florian, 71522 Backnang (DE)
(74) Vertreter: Ramrath, Lukas
(86) Internationale Anmeldenummer: PCT/EP2018/063001
(87) Internationale Veröffentlichungsnummer: WO 2019/219201

(56) Entgegenhaltungen:
- DE-A1- 19 821 371
- US-A1- 2018 045 511
- US-A1- 2018 089 360

## Beschreibung

Die Erfindung betrifft ein Verfahren und eine Vorrichtung zur Erzeugung eines Prüfplans für die Prüfung eines Messobjekts sowie ein Verfahren und eine Vorrichtung zur Prüfung des Messobjekts. Weiter betrifft die Erfindung ein Computerprogrammprodukt.

Es ist bekannt, für die Prüfung bzw. Vermessung von Werkstücken sogenannte Prüfpläne zu erzeugen, wobei ein solcher Prüfplan Parameter eines Prüfprozesses definiert, durch den die Qualität eines Werkstücks bzw. Messobjekts festgestellt werden kann. Ein derartiger Prüfplan kann beispielsweise anhand bestimmter allgemeiner Normen oder Hersteller- oder Kundenvorgaben festgelegt werden. Der Prüfplan wird hierbei durch ein entsprechendes Prüf- oder Messgerät durchgeführt, beispielsweise durch ein sogenanntes Koordinatenmessgerät.

In dem Prüfplan sind die zu prüfenden Prüfmerkmale eines zu vermessenden Werkstücks bzw. Informationen zu diesen Prüfmerkmalen enthalten. Solche Prüfmerkmale können beispielsweise sein der Abstand der Mittelpunkte zweier Bohrungen, die Abweichungen von Messpunkten auf einer Freiformfläche gegenüber einer Sollform, die Lage des Mittelpunktes einer Bohrung, der Durchmesser einer Bohrung etc. Ebenfalls kann der Prüfplan Informationen zu einer Lage und Gestalt des zu prüfenden Werkstücks, z.B. in einem Prüf-Koordinatensystem, und Informationen zu Soll-Werten von Prüfmerkmalen enthalten. Informationen zur Gestalt können z.B. in Form eines CAD-Modells im Prüfplan enthalten sein. Durch ein solches CAD-Modell können auch die erläuterten Soll-Werte festgelegt sein. Weiter kann der Prüfplan Toleranzangaben für ein Prüfmerkmal umfassen.

Weiter können durch den Prüfplan Arbeitsanweisungen zur Durchführung der durch den Prüfplan definierten Prüfung, z.B. in Form von Befehlen, die zur Durchführung und Datenerzeugung einzustellenden Prüfparameter, z.B. Beleuchtungsparameter oder Antastkräfte, sowie die zur Durchführung zu verwendenden Prüfkomponenten, z.B. Sensoren, festgelegt sein. Auch kann ein Prüfplan Prüfparameter enthalten, die zur Laufzeit der Prüfung eingestellt oder verändert werden können, z.B. um zeitlich nachfolgende Prüf(teil)prozesse anzupassen.

Weiter kann eine zur Durchführung der Prüfung abzufahrende Prüftrajektorie, z.B. eines Sensors, durch den Prüfplan festgelegt sein. Auch kann die Prüfergebnisdokumentation durch den Prüfplan festgelegt sein.

Während der Durchführung des Prüfplans erzeugte Ist-Informationen, z.B. Messpunkte, Bilder oder Messwerte, können ebenfalls im Prüfplan abgespeichert werden.

Wie vorhergehend erläutert können dann, basierend auf dem Prüfplan, durch eine Messeinrichtung bzw. ein Messgerät zu erfassende Messpunkte festgelegt werden, die zur Auswertung der Prüfmerkmale notwendig sind. Dann kann ein Messablauf definiert werden, um hierdurch Messpunkte auf der Oberfläche des zu vermessenden Werkstücks zu erfassen. In einem Prüfschritt bzw. Messschritt wird dann der so festgelegte Messablauf durch das Messgerät abgearbeitet, wodurch dann die benötigten Messpunkte gemäß dem durch den Prüfplan festgelegten Messablauf erfasst und gespeichert werden. Hiernach werden die einzelnen Prüfmerkmale des Prüfplans basierend auf den aufgenommenen Messpunkten ausgewertet und hierdurch die zur Erstellung eines Messprotokolls erforderlichen Daten gewonnen.

Beispielsweise ist in der Druckschrift DE 198 21 371 A1 ein Verfahren zum Vermessen eines Werkstücks mit einem automatisierten Messablauf und ein zur Ausführung des Verfahrens entsprechend eingerichtetes Koordinatenmessgerät beschrieben. Das Verfahren umfasst drei wesentliche Verfahrensschritte. In einem ersten Verfahrensschritt wird der automatische Messablauf festgelegt, wobei dieser anhand von Prüfmerkmalen festgelegt wird, die während eines Messablaufs ausgewertet werden sollen. Dabei werden unter Zuhilfenahme von CAD-Daten des Werkstückes Geometrieelemente auf der Werkstückoberfläche ausgewählt, die notwendig sind, um gewünschte Prüfmerkmale zu prüfen. Außerdem werden die Verfahrwege für den Sensor zum Abtasten der jeweiligen Geometrieelemente festgelegt. In einem zweiten Verfahrensschritt wird ein Werkstück dann gemäß dem Messablauf abgetastet. In einem dritten Verfahrensschritt werden die zu prüfenden Prüfmerkmale dann aufgrund der im Messablauf aufgenommenen Messdaten ausgewertet und an den Bediener des Koordinatenmessgeräts in nicht näher beschriebener Form ausgegeben. Eine solche Ausgabe erfolgt üblicherweise in Form eines Messprotokolls, das als elektronisches Dokument erzeugt wird, beispielsweise als PDF-Dokument.

Die WO 2014/19130 A1 offenbart ein Verfahren zur Erzeugung eines virtuellen Abbilds eines Messobjekts.

Die US2018/0089360 A1 offenbart Präzisionsmesstechnik, insbesondere Inspektionsprogramme für Koordinatenmessmaschinen.

Die US 2018/0045511 A1 offenbart ein Verfahren und eine Vorrichtung zum Bestimmung von vorliegenden dimensionellen Eigenschaften von einem gemessenen Objekt.

Weiter bekannt sind Anwendungen, bei denen Gruppen von an sich gleichförmigen Werkstücken vermessen werden müssen, wobei sich die Werkstücke aber in zumindest einer Dimension unterscheiden. Diese Dimension kann z.B. die Gesamtlänge sein. Zur Vermessung einer solchen Gruppe von Werkstücken muss der Anwender entweder stets einen Parameter, beispielsweise die Gesamtlänge, in einer Software des Messgeräts ändern oder jedes Mal die Werkstücklänge neu einmessen.

Es stellt sich das technische Problem, ein Verfahren, ein Programm und eine Vorrichtung zur Erzeugung eines Prüfplans für die Prüfung eines Messobjekts bzw. Werkstücks zu schaffen, welche die Erzeugung eines Prüfplans vereinfacht, insbesondere beschleunigt, und somit eine vereinfachte, insbesondere beschleunigte, Vermessung und Prüfung des Messobjekts ermöglicht.

Die Lösung des technischen Problems ergibt sich durch die Gegenstände mit den Merkmalen der unabhängigen Ansprüche 1, 13 und 14. Weitere vorteilhafte Ausgestaltungen der Erfindung ergeben sich aus den Unteransprüchen. Ferner versteht es sich, dass die in der einleitenden Beschreibung erwähnten Merkmale einzeln oder in beliebiger Kombination auch bei der vorliegend offenbarten Lösung vorgesehen sein können, sofern nicht anders angegeben oder ersichtlich.

Die Erfinder haben erkannt, dass der Aufwand zum Erstellen eines Prüfplans reduziert werden kann, wenn für Strukturen des gleichen oder ähnlichen Messobjekts, die ähnlich oder gleich zu einer bekannten Struktur sind, auf ein bereits existierendes Prüfmerkmal dieser bekannten Struktur zurückgegriffen wird.

Vorgeschlagen wird ein Verfahren zur Erzeugung eines Prüfplans für die Prüfung eines Messobjekts, welches z.B. ein Werkstück sein kann. Der Prüfplan kann insbesondere in elektronischer Form erzeugt werden. Wie vorhergehend erläutert, enthält bzw. kodiert ein solcher Prüfplan mindestens ein, vorzugsweise mehrere, Prüfmerkmal(e) des zu vermessenden Messobjekts. Basierend auf den Prüfplan können dann zu erfassenden Messpunkte und ein Messablauf zum Vermessen des Messobjekts durch eine entsprechende Messeinrichtung, insbesondere ein Koordinatenmessgerät, definiert werden. Verfahren zur Festlegung der Messpunkte und zur Erzeugung eines Messablaufs aus einem Prüfplan sind hierbei dem Fachmann bekannt und nicht Gegenstand dieser Erfindung.

In einem ersten Schritt wird ein das Messobjekt repräsentierender Datensatz bereitgestellt. Dieser Datensatz kann hierbei abgerufen werden, beispielsweise aus einer Speichereinrichtung, in der der Datensatz gespeichert ist. Ein solches Abrufen des Datensatzes kann insbesondere erfolgen, wenn der Datensatz ein Soll-Datensatz ist, beispielsweise ein CAD-Datensatz des Messobjekts. Alternativ kann der das Messobjekt repräsentierende Datensatz auch erzeugt werden, insbesondere durch eine Vermessung des Messobjekts. Die Vermessung kann hierbei durch eine entsprechende Messeinrichtung durchgeführt werden, insbesondere durch ein Koordinatenmessgerät.

Bei dem Messobjekt kann es sich um ein (insbesondere industriell gefertigtes) Bauteil oder Werkstück, eine Baugruppe oder ein allgemeines technisches System handeln. Der Datensatz kann auf Basis eines Vermessens von geometrischen Eigenschaften des Messobjekts erzeugt werden. Insbesondere kann der Datensatz Informationen enthalten oder definieren, die auf entsprechende geometrische Eigenschaften des Messobjekts schließen lassen oder diese angeben, wie zum Beispiel dessen Kontur, Umriss und/oder Form. Geeignete Datenformate bzw. -inhalte, um derartige Informationen oder Eigenschaften zu beschreiben sind dem Fachmann bekannt. Zusätzlich oder alternativ kann im Rahmen des Vermessens eine Orientierung und/oder Position des Messobjekts in einem vorbestimmten Koordinatensystem ermittelt werden und vorzugsweise auch in dem Datensatz (oder als ein zusätzlicher Datensatzteil) hinterlegt werden. Allgemein kann der Datensatz verschiedene Teilmengen oder Teildatensätze umfassen, die in ihrer Gesamtheit jedoch vorzugsweise die durch das Vermessen erhaltenen Informationen über das Messobjekt zusammenfassen.

Für eine Vermessung können verschiedene Messprinzipien angewendet werden, z.B. eine taktile Erfassung oder eine optische Erfassung des Messobjekts, um den entsprechenden Datensatz zu erzeugen. Somit kann der das Messobjekt repräsentierende Datensatz also ein Soll-Datensatz oder ein durch Vermessung erzeugter Datensatz sein. Das Vermessen kann mittels einer geeigneten Vermessungseinrichtung und/oder einem geeigneten Messsensor ausgeführt werden. Ein Beispiel für eine Vermessungseinrichtung ist ein Koordinatenmessgerät mit einem daran angebrachten taktilen oder berührungslosen Messsensor. Das Vermessen kann auch als eine optische Objektvermessung realisiert sein, beispielsweise auf Basis von Triangulation, Streifenprojektion und/oder einer Kameraerfassung. Zusätzlich oder alternativ kann das Vermessen auf Basis einer Objektdurchstrahlung ausgeführt werden, wobei zum Beispiel Magnet- und/oder Röntgenstrahlung zum Einsatz kommen kann. Ein Beispiel betrifft die Objektvermessung mittels Computertomografie (CT). Ferner kann das Messobjekt mittels Lichtprojektion und/oder Schattenwurf vermessen werden.

In einem weiteren, insbesondere zweiten, Schritt wird datenbasiert eine Referenzstruktur festgelegt. Im Rahmen der vorliegenden Offenbarung kann der Begriff datenbasiert allgemein bedeuten, das vorbestimmte bzw. ermittelte Daten (oder zumindest Teilmengen hiervon) herangezogen und/oder ausgewertet werden, um darauf basierend weitere Maßnahmen durchzuführen oder zu veranlassen.

Die Festlegung kann hierbei automatisch, semi-automatisch oder manuell, insbesondere durch eine entsprechende Eingabe eines Nutzers, erfolgen. Datenbasiert kann hierbei insbesondere bedeuten, dass die Referenzstruktur durch eine referenzstrukturspezifische (Teil-)Menge des Datensatzes repräsentiert wird. Diese referenzstrukturspezifische (Teil-)Menge kann dann automatisch, semi-automatisch oder manuell ausgewählt werden. Beispielsweise kann datenbasiert, insbesondere automatisch, mindestens eine Eigenschaft von verschiedenen Teil-Mengen des Datensatzes bestimmt und mit vorbestimmten Soll-Eigenschaften einer Referenzstruktur verglichen werden. Somit kann also eine potentielle Referenzstruktur mit einer vorbestimmten Soll-Referenzstruktur verglichen werden. Wenn die Abweichung der Eigenschaft einer dieser verschiedenen Teil-Mengen von der Soll-Eigenschaft ein vorbestimmtes Maß nicht überschreitet, kann diese als Referenzstruktur festgelegt werden. Semi-automatisch kann die Referenzstruktur festgelegt werden, indem z.B. einem Nutzer eine (Teil-)Menge des Datensatzes vorgeschlagen wird, der potentiell die Referenzstruktur repräsentiert und der Nutzer diesen Vorschlag dann durch eine Nutzerinteraktion bestätigt und/oder eine Auswahl zwischen einer etwaigen Mehrzahl an Vorschlägen trifft. Der Vorschlag kann insbesondere durch die vorhergehend erläuterte automatische Bestimmung einer entsprechenden Datenmenge erfolgen. Zur automatischen oder semi-automatischen Auswahl kann ein Vergleichsverfahren zum Vergleich einer potentiellen Referenzstruktur mit einer Soll-Referenzstruktur durchgeführt werden. Dieses kann dem nachfolgend noch näher erläuterten Vergleichsverfahren zum Vergleich der Referenzstruktur mit einer potentiell gleichen oder ähnlichen Struktur entsprechen, wodurch auf die entsprechenden Ausführungen verwiesen werden kann.

Es ist z.B. möglich, dass mindestens ein charakteristisches geometrisches Element oder eine charakteristische geometrische Eigenschaft im Datensatz detektiert wird, z.B. ein Sattelpunkt, ein Kreis, eine Kante, eine Ecke und/oder eine Linie. Eine Referenzstruktur kann in diesem Fall durch ein solches detektiertes Element oder eine solche detektierte Eigenschaft festgelegt sein, vorzugsweise durch eine geometrische Anordnung mehrerer Elemente oder Eigenschaften relativ zueinander.

Eine manuelle Festlegung der Referenzstruktur kann durch eine entsprechende Nutzereingabe erfolgen. Beispielsweise kann der Nutzer durch eine entsprechende Eingabe Datenpunkte oder Datenpunktmengen auswählen, durch die die von ihm gewünschte Referenzstruktur repräsentiert wird oder die eine Repräsentation der von ihm gewünschten Referenzstruktur enthalten oder umfassen.

In einem weiteren, insbesondere einem dritten, Schritt des Verfahrens wird der Referenzstruktur mindestens ein referenzstrukturspezifisches Prüfmerkmal zugeordnet. Mit anderen Worten wird für die Referenzstruktur das mindestens eine referenzstrukturspezifische Prüfmerkmal festgelegt. Beispielhafte Prüfmerkmale wurden einleitend bereits erläutert. Somit wird also eine Zuordnung von mindestens einem Prüfmerkmal zu der Referenzstruktur festgelegt. Diese Zuordnung kann gespeichert werden, insbesondere in einer Speichereinrichtung. Das Prüfmerkmal kann insbesondere eine dimensionelle Größe sein, beispielsweise eine Länge, ein Abstand, ein Durchmesser usw.

In einem weiteren, insbesondere vierten, Schritt des Verfahrens wird für den das Messobjekt repräsentierenden Datensatz datenbasiert geprüft, ob zur Referenzstruktur ähnliche oder gleiche Strukturen in diesem Datensatz vorhanden sind. Diese Prüfung kann automatisch oder semi-automatisch erfolgen.

Die datenbasierte Prüfung kann auch erfolgen, indem ein entsprechendes Vergleichsverfahren zum Vergleich der Referenzstruktur mit einer potentiell gleichen ähnlichen Struktur durchgeführt wird. Hierbei kann ein Vergleichsmaß bestimmt werden, wobei eine ähnliche oder gleiche Struktur detektiert wird, falls das Vergleichsmaß einem vorbestimmten Soll-Maß entspricht oder nicht mehr als ein vorbestimmtes Maß von diesem Soll-Maß abweicht.

Wie vorhergehend erläutert, kann hierzu z.B. mindestens eine datenbasiert bestimmbare referenzstrukturspezifische Eigenschaft der vorhergehend festgelegten Referenzstruktur bestimmt werden. Die datenbasiert bestimmbare referenzstrukturspezifische Eigenschaft bezeichnet hierbei eine Eigenschaft der Datenmenge, die eine Repräsentation der Referenzstruktur umfasst oder enthält. Diese kann dann mit einer Eigenschaft der potentiell gleichen oder ähnlichen Struktur verglichen werden. Die datenbasierte Prüfung kann in diesem Fall z.B. erfolgen, indem charakteristische geometrische oder dimensionelle Eigenschaften, z.B. eine Länge oder eine Breite, der Strukturen bestimmt und verglichen werden.

Ein solches Verfahren kann z.B. aber auch Mustervergleichsverfahren sein. Insbesondere kann ein Vergleichsverfahren ein form- oder strukturbasiertes Vergleich- oder Matchingverfahren sein, welche auch unter dem Begriff shape-based matching bekannt sind. Auch kann ein solches Verfahren ein Korrelationsverfahren, insbesondere ein Kreuzkorrelationsverfahren, sein. Auch kann ein solches Verfahren ein Abstandsbestimmungsverfahren, z.B. zur Bestimmung eines Abstands zwischen Intensitätswerten von Datenpunkten, sein.

Zur Durchführung des Vergleichsverfahrens kann es notwendig sein, zu vergleichende Muster in dem Datensatz/den Datensätzen zu bestimmen. Muster können hierbei ebenfalls datenbasiert bestimmt werden. Hierbei können Musterdetektionsverfahren angewendet werden. Beispielsweise kann mindestens ein geometrisches Element oder geometrische Eigenschaft im Datensatz detektiert werden, z.B. ein Sattelpunkt, ein Kreis, eine Kante, eine Ecke und/oder eine Linie. Dies kann durch ein entsprechendes Verfahren erfolgen, z.B. durch eine Sattelpunkt-, Kreis-, Kanten-, Ecken- und/oder Linienextraktion. Ein Muster kann in diesem Fall durch ein detektiertes Element oder eine detektierte Eigenschaft festgelegt sein, vorzugsweise durch eine geometrische Anordnung mehrerer Elemente oder Eigenschaften relativ zueinander. Es ist selbstverständlich möglich, dass Muster auf andere dem Fachmann bekannte Weisen detektiert werden.

Weiter kann/können dann der Datensatz, insbesondere verschiedene Teilmengen von Daten des Datensatzes, ausgewählt, dessen/deren Eigenschaft(en) bestimmt und mit der mindestens einen referenzstrukturspezifischen Eigenschaft verglichen werden. Eine ähnliche Struktur kann detektiert werden, wenn die derart bestimmte mindestens eine Eigenschaft nicht mehr als ein vorbestimmtes Maß von der referenzstrukturspezifischen Eigenschaft abweicht. Eine gleiche Struktur kann detektiert werden, wenn die derart bestimmte mindestens eine Eigenschaft der referenzstrukturspezifischen Eigenschaft der Referenzstruktur entspricht.

Hierfür kann der Datensatz auf verschiedene Teilmengen hin durchsucht werden. Die Durchsuchung des Datensatzes kann hierbei erfolgen, indem der Datensatz in verschiedene Teilmengen gleicher Größe unterteilt wird, wobei jede dieser Teilmengen dann entsprechend untersucht wird. Die Teilmengen können sich hierbei zumindest teilweise überschneiden. Allerdings ist es auch möglich, dass die Teilmengen disjunkt sind. Weiter ist es möglich, verschiedene Durchläufe des Durchsuchens durchzuführen, wobei eine Größe und/oder Form der Teilmengen variiert wird.

Bei einer semi-automatischen Prüfung kann, wie vorhergehend erläutert, ebenfalls eine eigenschaftsbasierte Detektion von ähnlichen oder gleichen Strukturen durchgeführt werden, wobei jedoch nur ein Kandidat für eine ähnliche oder gleiche Struktur ermittelt wird und zur Bestätigung einem Nutzer oder übergeordneten System als potentiell ähnliche oder gleiche Struktur vorgeschlagen wird. In diesem Fall wird die vorgeschlagene Struktur erst dann als gleiche oder ähnliche Struktur bestimmt, wenn der Vorschlag von dem Nutzer oder übergeordneten System bestätigt wird.

In einem weiteren, insbesondere fünften, Schritt wird jeder ähnlichen oder gleichen Struktur das vorhergehend festgelegte referenzstrukturspezifische Prüfmerkmal als strukturspezifisches Prüfmerkmal zugeordnet. Mit anderen Worten wird also einer ähnlichen oder gleichen Struktur, die zusätzlich zu der Referenzstruktur durch den Datensatz, insbesondere durch eine andere Teilmenge des Datensatzes, repräsentiert wird, das gleiche Prüfmerkmal zugeordnet wie der Referenzstruktur.

Der resultierende Prüfplan umfasst dann alle der derart bestimmten strukturspezifischen Prüfmerkmale, also insbesondere das mindestens eine referenzstrukturspezifische Prüfmerkmal sowie für jede ähnliche oder gleiche Struktur mindestens ein strukturspezifisches Prüfmerkmal, welches dem referenzstrukturspezifischen Prüfmerkmal entspricht.

Hierdurch kann in vorteilhafter Weise erreicht werden, dass ein Nutzer zur Erzeugung des Prüfplans nicht manuell alle zu prüfenden Strukturen in dem Datensatz festlegen muss. Hierdurch wird einerseits die Zeitdauer zur Erzeugung eines Prüfplans und somit auch zur Prüfung des Messobjekts reduziert, andererseits wird auch eine Bedienerfreundlichkeit bei der Erzeugung des Prüfplans erhöht.

Zusätzlich zu den Prüfmerkmalen, die für das zu vermessende Objekt zu bestimmen sind, kann der Prüfplan auch weiter mindestens ein Prüfkriterium enthalten, welches einem solchen Prüfmerkmal zugeordnet ist. Dieses Prüfkriterium kann dann nach der Vermessung des Messobjekts auf Grundlage des Prüfplans und nach Bestimmung des Prüfmerkmals in Abhängigkeit des somit erzeugten Messdatensatzes ausgewertet werden. Das Prüfkriterium kann insbesondere die Art eines Vergleichs eines erfassten Ist-Merkmals mit einem Soll-Merkmal festlegen. Dies wird nachfolgend noch näher erläutert.

Es ist weiter möglich, dass ein Prüfmerkmal die Anzahl von gleichen oder ähnlichen Struktur ist, die in dem das Messobjekt repräsentierenden Datensatz vorhanden sind. Ein Prüfkriterium kann in diesem Fall sein, ob diese Anzahl einer vorbestimmten Anzahl oder einer in einem Soll-Datensatz vorhandenen Anzahl entspricht.

Die Prüfung, ob zur Referenzstruktur ähnliche oder gleiche Strukturen vorhanden sind, kann für den das Messobjekt repräsentierenden Datensatz, auf dessen Grundlage die Referenzstruktur festgelegt wird, erfolgen. Alternativ kann die Prüfung, ob zur Referenzstruktur ähnliche oder gleiche Strukturen vorhanden sind, auch in einem weiteren Datensatz erfolgen. Dieser weitere Datensatz kann hierbei eine weitere Repräsentation des Messobjekts sein.

Daten des weiteren Datensatzes können hierbei das gleiche Messobjekt wie die Daten des Datensatzes, auf dessen Grundlage die Referenzstruktur festgelegt wird repräsentieren. Allerdings können diese Daten durch ein anderes Verfahren erzeugt werden als Daten des Datensatzes, auf dessen Grundlage die Referenzstruktur festgelegt wird, z.B. durch ein anderes Konstruktions- oder Messverfahren.

Alternativ können Daten des weiteren Datensatzes ein weiteres Messobjekt repräsentieren, insbesondere ein Messobjekt des gleichen Typs, der gleichen Bauserie oder gleichen Kategorie.

Es ist weiter möglich, dass bei der Festlegung der Referenzstruktur auch eine Position und/oder Orientierung der Referenzstruktur bestimmt und gegebenenfalls gespeichert wird, insbesondere um nachfolgend Messpunkte festzulegen. Die Position und/oder Orientierung kann hierbei in einem vorbestimmten Koordinatensystem, beispielsweise einem Koordinatensystem des Datensatzes oder in einem Koordinatensystem des Messobjekts bestimmt werden. Durch eine entsprechende Registrierung kann eine räumliche Beziehung zwischen verschiedenen Koordinatensystemen vorbekannt sein.

Weiter ist es möglich, dass auch Positionen und/oder Orientierungen der ähnlichen oder gleichen Strukturen bestimmt werden, insbesondere um nachfolgend weitere Messpunkte festzulegen. Auch diese können gespeichert werden.

Somit kann der Prüfplan neben den referenzstrukturspezifischen und strukturspezifischen Prüfmerkmalen auch die referenzstrukturspezifische Position/Orientierung und/oder die strukturspezifischen Positionen und/oder Orientierungen enthalten.

In einer weiteren Ausführungsform wird der Referenzstruktur mindestens ein Geometrieelement zugeordnet, wobei das referenzstrukturspezifische Prüfmerkmal auf Grundlage bzw. in Abhängigkeit des mindestens einen Geometrieelements bestimmt wird.

Das Geometrieelement kann hierbei entsprechend den vorhergehenden Erläuterungen der Referenzstruktur automatisch, semi-automatisch oder durch einen Nutzer zugeordnet werden.

Ein Geometrieelement kann insbesondere ein Element aus der Liste Punkt, Gerade, Linie, Kurve, Freiformfläche, Ebene, Torus, Kegel, Paraboloid, Kugel, Zylinder, Ellipse, Kreis, Langloch, Nut und Rechteck sein. Anhand des Geometrieelements können insbesondere die für die Bestimmung des Prüfmerkmals zu erfassenden Messpunkte des Messobjekts, insbesondere auf der Oberfläche des Messobjekts, definiert werden. Soll z.B. die Rundheit eines zylinderförmigen Sacklochs oder einer zylinderförmigen Durchgangsöffnung als Prüfmerkmal bestimmt werden, insbesondere in einer vorbestimmten Stelle oder Höhe des Sacklochs oder der Durchgangsöffnung, so kann als das dem Prüfmerkmal zuzuordnende Geometrieelement der Kreis festgelegt werden.

Dies wiederum ermöglicht in vorteilhafter Weise die vereinfachte Ansteuerung einer Messeinrichtung, um die Messpunkte zu erfassen.

Mit anderen Worten enthält der Prüfplan dann zusätzlich zu dem referenzstrukturspezifischen Prüfmerkmal auch mindestens ein referenzstrukturspezifisches Geometrieelement. Werden ähnliche oder gleiche Strukturen bestimmt und diesen das referenzstrukturspezifische Prüfmerkmal zugeordnet, so sind diesen strukturspezifischen Prüfmerkmalen als Resultat ebenfalls das mindestens eine Geometrieelement zugeordnet. Informationen des Geometrieelements können genutzt werden, um entsprechende Messpunkte festzulegen.

Hierdurch ergibt sich in vorteilhafter Weise eine weitere Beschleunigung bei der Erzeugung des Prüfplans sowie eine weitere Verbesserung der Bedienfreundlichkeit, da z.B. ein Nutzer für eine Struktur nur einmalig, nämlich für die Referenzstruktur, ein oder mehrere Geometrieelement(e) festlegen muss, die zur Bestimmung des Prüfmerkmals notwendig, insbesondere bei der späteren Vermessung zu erfassen sind.

In einer weiteren Ausführungsform wird der das Messobjekt repräsentierende Datensatz, in dem dann die Referenzstruktur bestimmt wird, durch eine Vermessung des jeweiligen Messobjekts erzeugt. Die Vermessung kann hierbei wie vorhergehend erläutert mit verschiedenen Messverfahren, insbesondere taktilen Messverfahren oder optischen Messverfahren, erfolgen. Insbesondere kann hierbei eine Form einer Oberfläche des Messobjekts vermessen werden. Hierbei können auch verschiedene Messeinrichtungen eingesetzt werden, insbesondere das vorhergehend erläuterte Koordinatenmessgerät.

Hierbei ist es in vorteilhafter Weise möglich, dass in einem Messdatensatz einmalig eine Referenzstruktur festgelegt wird, beispielsweise durch einen Nutzer, wobei dann ein Messdatensatz nach gleichen oder ähnlichen Strukturen automatisch oder semi-automatisch durchsucht werden kann und diesen Strukturen dann zur Erzeugung des Prüfplans das referenzstrukturspezifische Prüfmerkmal zugeordnet werden kann. Dies beschleunigt die Erzeugung des Prüfplans für ein vermessenes Messobjekt und somit auch die Prüfung.

Es ist in diesem Fall möglich, dass die Prüfung des Messobjekts, also die Auswertung von prüfmerkmalbasierten Prüfungskriterien, dann ebenfalls in Abhängigkeit dieses durch Vermessung erzeugten Datensatzes durchgeführt wird.

Alternativ kann der das Messobjekt repräsentierende Datensatz ein Soll-Datensatz sein. Ein solcher Soll-Datensatz kann insbesondere ein Konstruktionsdatensatz sein, beispielsweise ein CAD-Datensatz. In diesem Fall kann die Suche nach ähnlichen oder gleichen Strukturen vorzugsweise in einem wie vorhergehend erläuterten weiteren Datensatz durchgeführt werden, insbesondere in einem durch Vermessung eines Messobjekts erzeugten Datensatz, wobei dieses Messobjekt gemäß den Informationen des Konstruktionsdatensatzes erzeugt wurde. Es ist in diesem Fall möglich, dass die Prüfung des Messobjekts, also die Auswertung von prüfmerkmalbasierten Prüfungskriterien, dann ebenfalls in Abhängigkeit dieses durch Vermessung erzeugten weiteren Datensatzes durchgeführt wird.

Es ist allerdings auch möglich, gleiche oder ähnliche Strukturen auch in dem Soll-Datensatz zu bestimmen. In diesem Fall können dann Positions- und/oder Orientierungsinformationen dieser Strukturen gespeichert und zur Suche in einem weiteren Datensatz genutzt werden, beispielsweise zur Auswahl von zu durchsuchenden Teilmengen des weiteren Datensatzes.

Hierdurch ergibt sich in vorteilhafter Weise, dass ein Nutzer bereits vor der eigentlichen Vermessung aufgrund des idealerweise fehlerfreien Soll-Datensatzes in zuverlässiger Weise angeben kann, welche Strukturen und Prüfmerkmale er gerne zur Prüfung des Messobjekts auswerten möchte. Dies wiederum erhöht eine Benutzerfreundlichkeit.

In einer weiteren Ausführungsform wird für einen weiteren Datensatz, der das Messobjekt oder ein weiteres Messobjekt repräsentiert, datenbasiert geprüft, ob zur Referenzstruktur ähnliche oder gleiche Strukturen in diesem weiteren Datensatz vorhanden sind. Weiter wird jeder dieser ähnlichen oder gleichen Strukturen das referenzstrukturspezifische Prüfmerkmal zugeordnet, wobei der Prüfplan dann die derart bestimmten strukturspezifischen Prüfmerkmale umfasst. Der weitere Datensatz wurde vorhergehend bereits erläutert.

Hierdurch ergibt sich in vorteilhafter Weise die Beschleunigung der Erzeugung von Prüfplänen für mehrere Messobjekte, insbesondere ähnliche oder gleichartige Messobjekte, wobei die Referenzstruktur nur einmalig, insbesondere in einem Soll-Datensatz dieser ähnlichen oder gleichartigen Messobjekte oder in einem durch Vermessung erzeugten Datensatz von genau einem dieser ähnlichen oder gleichartigen Messobjekte, festgelegt werden muss. Dies erhöht wiederum die Benutzerfreundlichkeit bei der Erzeugung von Prüfplänen.

In einer weiteren Ausführungsform wird der weitere Datensatz durch eine Vermessung des Messobjekts oder eines gleichartigen Messobjekts erzeugt. Dies kann insbesondere dann erfolgen, wenn der Datensatz, in dem die Referenzstruktur festgelegt wird, ein Soll-Datensatz des Messobjekts ist. Dies und entsprechende Vorteile wurden vorhergehend bereits erläutert. Ein gleichartiges Messobjekt kann ein Messobjekt des gleichen Typs oder der gleichen Bauserie bezeichnen.

In einer weiteren Ausführungsform werden bei der datenbasierten Prüfung, ob zur Referenzstruktur ähnliche oder gleiche Strukturen im weiteren Datensatz vorhanden sind, vorbekannte oder vorhergehend bestimmte strukturspezifische Positionsinformationen und/oder Orientierungsinformationen berücksichtigt.

Beispielsweise können strukturspezifische Positionsinformationen und/oder Orientierungsinformationen zur Auswahl von zu durchsuchenden Teilmengen des weiteren Datensatzes genutzt werden, wobei diese Positionsinformationen und/oder Orientierungsinformationen bei der Auswertung eines vom weiteren Datensatz verschiedenen Datensatzes, der auch als Strukturpositionsdatensatz bezeichnet werden kann, bestimmt wurden. Hierbei kann also datenbasiert geprüft werden, ob im Strukturpositionsdatensatz zur Referenzstruktur gleiche oder ähnliche Strukturen vorhanden sind, wobei dann eine strukturspezifische Positionsinformation und/oder Orientierungsinformation zur weiteren Verwendung bestimmt werden kann.

Der Strukturpositionsdatensatz kann insbesondere ein Soll-Datensatz sein. Alternativ kann der Strukturpositionsdatensatz ein Datensatz sein, der mit einem Messverfahren erzeugt wurde, welches von dem Messverfahren zur Erzeugung des weiteren Datensatzes verschieden ist. So ist es z.B. möglich, mit einem optischen Messverfahren einen Datensatz von dem Messobjekt zu erzeugen, wobei dieser Datensatz den Strukturpositionsdatensatz bildet. Der weitere Datensatz kann dann mit einem taktilen Messverfahren erzeugt werden. Mit anderen Worten kann zusätzlich zu dem weiteren Datensatz, insbesondere zeitlich vor der Erzeugung des weiteren Datensatzes, ein Strukturpositionsdatensatz erzeugt werden, der dann zur Bestimmung von Positionsinformationen und/oder Orientierungsinformationen genutzt wird. Es ist möglich, dass der Strukturpositionsdatensatz zur Laufzeit der Durchführung des Verfahrens erzeugt wird.

Durch die Erzeugung eines Strukturpositionsdatensatzes kann in vorteilhafter Weise erreicht werden, dass möglichst alle gleichen oder ähnlichen Strukturen geprüft werden, insbesondere wenn diese beim tatsächlichen Messobjekt aufgrund von Toleranzen an einer unerwarteten Position angeordnet sind.

Es ist allerdings auch möglich, dass strukturspezifische Positionsinformationen und/oder Orientierungsinformationen während der Bestimmung von gleichen oder ähnlichen Strukturen in einem Datensatz, insbesondere einem Soll-Datensatz, bestimmt werden.

Alternativ können diese strukturspezifische Positionsinformationen und/oder Orientierungsinformationen auch vorbekannt sein. Ist beispielsweise bekannt, dass das Messobjekt eine Anordnung von mehreren gleichen oder ähnlichen Strukturen umfasst, z.B. mehrere zylinderförmige Sackloch- oder Durchgangsöffnungen auf einer Kreislinie, eine matrixartige Anordnung von derartigen Öffnungen oder eine Wabenstruktur, so können vorbekannte Positionsinformationen und/oder Orientierungsinformationen, die sich aus dieser Anordnung ergeben, beispielsweise Informationen über eine Soll-Relativposition und/oder Soll-Relativorientierung zwischen den Strukturen, bei der Suche nach diesen gleichen oder ähnlichen Strukturen in dem Datensatz berücksichtigt werden. Insbesondere kann aufgrund der strukturspezifische Positionsinformationen und/oder Orientierungsinformationen die auf gleiche oder ähnliche Strukturen hin zu durchsuchenden Teilmengen des weiteren Datensatzes festgelegt werden.

Auch kann, insbesondere aufgrund von Informationen über eine relative Position und/oder Orientierung von gleichen oder ähnlichen Strukturen, nach der Detektion einer ersten ähnlichen oder gleichen Struktur ein Teilbereich für die Suche einer weiteren gleichen oder ähnlichen Struktur festgelegt werden, insbesondere in Abhängigkeit der Position und/oder Orientierung der ersten detektierten Struktur.

Wurden also in einem oder in mehreren Datensatz/Datensätzen eine Referenzstruktur und mindestens eine gleiche oder ähnliche Struktur festgelegt/bestimmt, so können die entsprechenden Positions- und/oder Orientierungsinformationen genutzt werden, um in einem weiteren Datensatz Teilbereiche zur Suche der ähnlichen oder gleichen Strukturen festzulegen. Selbstverständlich sind hierbei die Teilbereiche derart zu wählen, dass Toleranzen, insbesondere für die aus der Vermessung resultierenden Ungenauigkeiten, berücksichtigt werden. Hierdurch ergibt sich in vorteilhafter Weise eine weitere Beschleunigung bei der Erzeugung des Prüfplans.

Werden bei der datenbasierten Prüfung, ob zur Referenzstruktur ähnliche oder gleiche Strukturen im weiteren Datensatz vorhanden sind, vorbekannte oder vorhergehend bestimmte strukturspezifische Positionsinformationen und/oder Orientierungsinformationen berücksichtigt, so kann ein Prüfkriterium sein, ob die Position und/oder Orientierung einer ähnlichen oder gleichen Struktur im weiteren Datensatz nicht mehr als ein vorbestimmtes Maß von der durch die strukturspezifische Positionsinformation und/oder Orientierungsinformation festgelegten Position und/oder Orientierung abweicht.

In einer weiteren Ausführungsform ist ein das Messobjekt repräsentierender Datensatz ein dreidimensionaler Datensatz. Ein dreidimensionaler Datensatz bezeichnet hierbei eine räumliche Repräsentierung des Messobjekts in drei Dimensionen, mit anderen Worten ein Volumendatensatz. Ein dreidimensionaler Datensatz kann insbesondere durch Voxel gebildet werden oder Voxel umfassen. Weiter kann ein dreidimensionaler Datensatz durch eine Punktwolke oder ein Polygonnetz, insbesondere ein Dreiecknetz, festgelegt sein. Auch kann ein dreidimensionaler Datensatz in Form eines CAD-Modells festgelegt sein. Dies kann z.B. eine mathematische Beschreibung des Messobjekts durch Kurven und Flächen sein.

In einer alternativen Ausführungsform ist ein das Messobjekt repräsentierender Datensatz ein zweidimensionaler Datensatz. Ein zweidimensionaler Datensatz kann eine Repräsentierung des Messobjekts in zwei Dimensionen bezeichnen. Ein zweidimensionaler Datensatz kann insbesondere ein zweidimensionales Abbild des Messobjekts sein. Ein zweidimensionaler Datensatz kann insbesondere durch Pixel gebildet werden oder Pixel umfassen.

In einer weiteren Ausführungsform ist der Datensatz ein Bilddatensatz. Dies kann bedeuten, dass der Datensatz durch ein bildgebendes Messverfahren erzeugt wurde, beispielsweise durch Abbildung mittels einer optischen Erfassungseinrichtung oder Abbildung mittels einer CT-Einrichtung. Weiter kann auch ein Soll-Datensatz ein Bilddatensatz sein, insbesondere ein CAD-Datensatz.

In einer weiteren Ausführungsform wird der Referenzstruktur ein Prüfmerkmal in Abhängigkeit einer vorbekannten Zuordnung zugeordnet. Die vorbekannte Zuordnung kann beispielsweise in Form einer Bibliothek gegeben sein, wobei diese vorbekannte Zuordnung mehrere voneinander verschiedene Strukturen umfassen kann, wobei jeder dieser Strukturen mindestens ein Prüfmerkmal zugeordnet sein kann. Beispielsweise kann bestimmt werden, ob die in dem Datensatz bestimmte Referenzstruktur gleich oder ähnlich zu einer der in der Zuordnung vorhandenen Strukturen ist. Ist dies der Fall, kann der Referenzstruktur das entsprechende Prüfmerkmal bzw. die entsprechenden Prüfmerkmale zugeordnet werden.

Hierdurch wird in vorteilhafter Weise eine weitere Beschleunigung bei der Erzeugung eines Prüfplans erreicht, da vorbekannte Zuordnungen genutzt werden können. Diese Zuordnung kann z.B. bei der vorhergehend erläuterten automatischen Zuordnung von Prüfmerkmalen bzw. semiautomatischen Zuordnung von Prüfmerkmalen genutzt werden.

Alternativ oder kumulativ wird der Referenzstruktur ein Geometrieelement in Abhängigkeit einer vorbekannten Zuordnung zugeordnet. Somit kann eine weitere Zuordnung vorhanden sein, beispielsweise in Form einer Bibliothek, die mehrere Strukturen umfasst, wobei jeder dieser Strukturen mindestens ein Geometrieelement zugeordnet ist. Beispielsweise kann bestimmt werden, ob die in dem Datensatz bestimmte Referenzstruktur gleich oder ähnlich zu einer der in der Zuordnung vorhandenen Strukturen ist. Ist dies der Fall, kann der Struktur das entsprechende Geometrieelement bzw. die entsprechenden Geometrieelemente zugeordnet werden.

Weiter alternativ oder kumulativ kann einem Prüfmerkmal mindestens ein Geometrieelement in Abhängigkeit einer vorbekannten Zuordnung zugeordnet sein. Somit kann eine weitere Zuordnung vorhanden sein, beispielsweise in Form einer Bibliothek, die mehrere Prüfmerkmale umfasst, wobei jedem dieser Merkmale mindestens ein Geometrieelement zugeordnet ist. Beispielsweise kann bestimmt werden, ob das bestimmte Merkmal gleich oder ähnlich zu einem der in der Zuordnung vorhandenen Merkmale ist. Ist dies der Fall, kann dem Merkmal das entsprechende Geometrieelement bzw. die entsprechenden Geometrieelemente zugeordnet werden.

Es ist auch möglich, dass einem Nutzer oder einem übergeordneten System in Abhängigkeit der Zuordnung zwischen Prüfmerkmal und mindestens einem Geometrieelement ein Prüfmerkmal vorgeschlagen wird. So kann der Datensatz auf ein Geometrieelement hin durchsucht werden, wobei dann ein zugeordnetes Prüfmerkmal vorgeschlagen wird, wenn das Geometrieelement oder ein dazu ähnliches Geometrieelement gefunden wurde. Dies kann z.B. bei der automatischen oder semi-automatischen Festlegung von Prüfmerkmalen genutzt werden.

Es ist möglich, dass die vorbekannte Zuordnung(en) erweitert wird, beispielsweise wenn ein Nutzer eine in der Zuordnung noch nicht vorhandene Referenzstruktur festlegt und dieser ein Prüfmerkmal und/oder ein Geometrieelement zuordnet. Diese Zuordnung kann dann in die bestehende Zuordnung aufgenommen werden.

In einer weiteren Ausführungsform ist ein Kriterium zur Bestimmung der Ähnlichkeit von Strukturen in einem Soll-Datensatz schärfer als ein Kriterium zur Bestimmung der Ähnlichkeit von Strukturen in einem durch Vermessung erzeugten Datensatz. Insbesondere kann in einem Soll-Datensatz geprüft werden, ob zur Referenzstruktur gleiche Strukturen vorhanden sind, wobei jedoch nicht geprüft wird, ob zur Referenzstruktur ähnliche Strukturen vorhanden sind. In einem durch Vermessung erzeugten Messdatensatz kann im Gegensatz hierzu geprüft werden, ob zur Referenzstruktur ähnliche oder gleiche Strukturen vorhanden sind. Alternativ kann das Maß einer zulässigen Abweichung zwischen einer Eigenschaft der Referenzstruktur und einer entsprechenden Eigenschaft einer ähnlichen Struktur bei der Auswertung eines Soll-Datensatzes geringer sein als bei der Auswertung eines durch Vermessung erzeugten Datensatzes.

Somit kann das erfindungsgemäße Verfahren einen weiteren Teilschritt umfassen, wobei in diesem Teilschritt ein Kriterium zur Prüfung auf ähnliche oder gleiche Strukturen festgelegt wird, wobei diese Festlegung in Abhängigkeit von der Art des Datensatzes erfolgt, nämlich in Abhängigkeit, ob der Datensatz ein Soll-Datensatz oder ein durch Vermessung erzeugter Datensatz ist. Dieser Teilschritt kann insbesondere vor der Prüfung auf ähnliche oder gleiche Strukturen ausgeführt werden.

In einer weiteren Ausführungsform wird das Verfahren als Simulation durchgeführt. Mit anderen Worten ist es möglich, dass ein das Messobjekt repräsentierender Datensatz durch eine Simulation eines Messverfahrens erzeugt wird. Hierzu kann z.B. ein Verfahren zur Erzeugung eines virtuellen Abbilds des Messobjekts angewendet werden. Ein solches Verfahren ist z.B. in der WO 2014/19130 A1 offenbart. Solche Verfahren ermöglichen insbesondere auch die Simulation von optischen oder taktilen Messverfahren.

Weiter vorgeschlagen wird ein Programm, welches, wenn es auf oder durch einen Computer oder der vorhergehend beschriebenen Auswerteeinrichtung ausgeführt wird, den Computer veranlasst, einen, mehrere oder alle Schritte des in dieser Offenbarung dargestellten Verfahrens zur Erzeugung eines Prüfplans für die Prüfung eines Messobjekts durchzuführen. Alternativ oder kumulativ wird ein Programmspeichermedium oder Computerprogrammprodukt beschrieben, auf oder in dem das Programm gespeichert ist, insbesondere in einer nicht vorübergehenden, z.B. in einer dauerhaften, Form. Alternativ oder kumulativ wird ein Computer beschrieben, der dieses Programmspeichermedium umfasst. Weiter alternativ oder kumulativ wird ein Signal beschrieben, beispielsweise ein digitales Signal, welches Informationen codiert, die das Programm repräsentieren und welches Code-Mittel umfasst, die adaptiert sind, einen, mehrere oder alle Schritte des in dieser Offenbarung dargestellten Verfahrens zur Erzeugung eines Prüfplans für die Prüfung eines Messobjekts durchzuführen. Das Signal kann ein physikalisches Signal, zum Beispiel ein elektrisches Signal sein, welches insbesondere technisch oder maschinell erzeugt wird.

Weiter ist das Verfahren zur Erzeugung eines Prüfplans für die Prüfung eines Messobjekts ein computerimplementiertes Verfahren. Eine Ausführungsform für das computerimplementierte Verfahren ist die Benutzung des Computers zur Durchführung einer Datenverarbeitungsmethode. Der Computer kann zum Beispiel zumindest eine Recheneinrichtung, insbesondere ein Prozessor, und zum Beispiel zumindest eine Speichereinrichtung umfassen, um die Daten, insbesondere technisch, zu verarbeiten, zum Beispiel elektronisch und oder optisch. Ein Computer kann hierbei jede Art von Datenverarbeitungsgerät sein. Ein Prozessor kann ein halbleiterbasierter Prozessor sein.

Weiter vorgeschlagen wird eine Vorrichtung zur Erzeugung eines Prüfplans für die Prüfung eines Messobjekts. Die Vorrichtung dient hierbei zur Durchführung eines Verfahrens zur Erzeugung eines Prüfplans gemäß einer der in dieser Erfindung offenbarten Ausführungsform. Somit ist die Vorrichtung entsprechend ausgebildet.

Die Vorrichtung umfasst mindestens eine Schnittstelle zum Einlesen eines Datensatz und mindestens eine Auswerteeinrichtung. Die Auswerteeinrichtung kann mindestens eine Recheneinrichtung, insbesondere einen als Mikrocontroller oder Prozessor ausgebildete Recheneinrichtung umfassen. Die Auswerteeinrichtung kann auch ein Computer oder ein Teil davon sein. Weiter ist ein das Messobjekt repräsentierender Datensatz über die Schnittstelle einlesbar. Wie vorhergehend erläutert, kann dieser Datensatz ein Soll-Datensatz, der beispielsweise in einer Speichereinrichtung gespeichert ist, oder ein durch Vermessung erzeugter Datensatz sein.

Weiter ist, insbesondere durch die Auswerteeinrichtung, datenbasiert eine Referenzstruktur festlegbar und der Referenzstruktur mindestens ein referenzstrukturspezifisches Prüfmerkmal zuordenbar. Weiter ist, insbesondere ebenfalls mittels der vorhergehend erläuterten Auswerteeinrichtung, für den das Messobjekt repräsentierenden Datensatz datenbasiert prüfbar, ob zur Referenzstruktur ähnliche oder gleiche Strukturen vorhanden sind, wobei jeder ähnlichen oder gleichen Struktur das referenzstrukturspezifische Prüfmerkmal als strukturspezifisches Prüfmerkmal zuordenbar ist, wobei der Prüfplan die derart bestimmten strukturspezifischen Prüfmerkmale umfasst.

Die Vorrichtung kann hierbei weiter eine Eingabeeinrichtung für Nutzereingaben, beispielsweise in Form eines Touchscreens, einer Tastatur, einer Maus oder in Form weiterer Eingabeeinrichtungen, umfassen.

Weiter kann die Vorrichtung mindestens eine Speichereinrichtung, insbesondere zum Speichern eines Soll-Datensatzes, zum Speichern von Prüfmerkmalen, zum Speichern eines Messdatensatzes, zum Speichern von Zuordnungen, zum Speichern von Positionen und/oder Orientierung usw. umfassen.

Weiter kann die Vorrichtung auch eine Messeinrichtung zur Vermessung des Messobjekts umfassen.

Weiter vorgeschlagen wird ein Verfahren zur Prüfung bzw. Vermessung eines Messobjekts. Bei diesem Verfahren wird ein Prüfplan gemäß einer in dieser Offenbarung beschriebenen Ausführungsform eines Verfahrens zur Erzeugung eines Prüfplans erzeugt. Der Prüfplan kann hierbei auf Grundlage eines durch Vermessung des Messobjekts oder eines ähnlichen Messobjekts oder auf Grundlage eines Soll-Datensatzes erzeugt werden.

Weiter wird das Messobjekt auf Grundlage dieses Prüfplans vermessen. Insbesondere können, wie vorhergehend bereits erläutert, auf Grundlage des Prüfplans zu erfassende Messpunkte des Messobjekts festgelegt werden. Diese können dann bei der Vermessung erfasst werden. Auf Grundlage der Messpunkte können dann, wie vorhergehend ebenfalls bereits erläutert, die Prüfmerkmale erfasst werden. Weiter können Prüfkriterien auf Grundlage dieser Prüfmerkmale ausgewertet werden, beispielsweise durch sogenannte schwellwertbasierte Verfahren.

Es ist möglich, dass das Verfahren zur Prüfung als Simulation durchgeführt wird. Hierbei kann insbesondere die Vermessung simuliert werden, insbesondere indem ein virtuelles Abbild eines zu prüfenden Messobjekts erzeugt wird und diese virtuelle Repräsentation des Messobjekts auf Grundlage des Prüfplans vermessen wird, insbesondere durch Simulation eines Messverfahrens. Hierzu wird erneut auf die vorhergehend erläuterte WO 2014/19130 A1 verwiesen.

Weiter vorgeschlagen wird auch eine Vorrichtung zur Prüfung eines Messobjekts. Die Vorrichtung umfasst hierbei eine Vorrichtung zur Erzeugung eines Prüfplans gemäß einer der in dieser Offenbarung beschriebenen Ausführungsform. Weiter umfasst die Vorrichtung eine Messeinrichtung. Weiter kann die Vorrichtung eine Steuereinrichtung umfassen. Mittels der Steuereinrichtung ist die Messeinrichtung derart steuerbar, dass Messpunkte des Messobjekts, die in Abhängigkeit des Prüfplans festgelegt wurden, erfassbar sind.

Die Vorrichtung dient hierbei in vorteilhafter Weise der Durchführung eines Verfahrens zur Prüfung eines Messobjekts gemäß einer der in dieser Offenbarung beschriebenen Ausführungsform.

Die Erfindung wird anhand von Ausführungsbeispielen näher erläutert. Die Figuren zeigen:

Nachfolgend bezeichnen gleiche Bezugszeichen Elemente mit gleichen oder ähnlichen technischen Merkmalen.

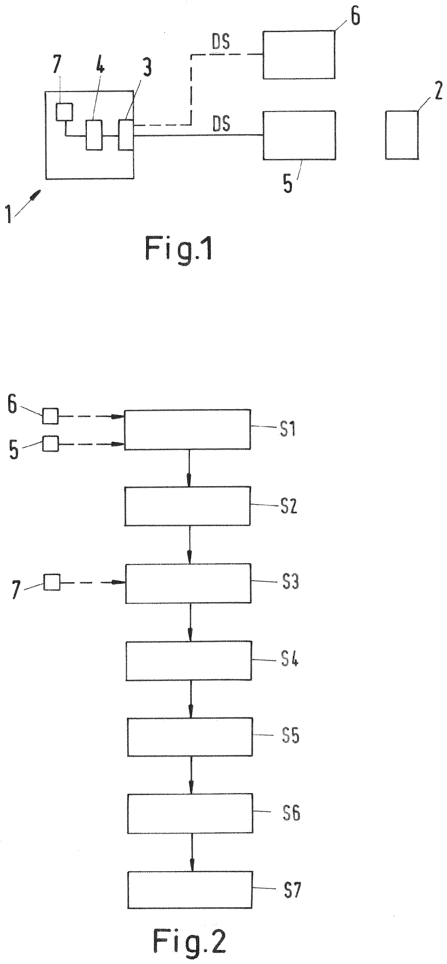

In Fig. 1 ist ein schematisches Blockschaltbild einer erfindungsgemäßen Vorrichtung 1 zur Erzeugung eines Prüfplans für die Prüfung eines Messobjekts 2 dargestellt. Die Vorrichtung 1 umfasst eine Schnittstelle 3 zum Einlesen eines Datensatzes DS und mindestens eine Auswerteeinrichtung 4. In Fig. 1 ist dargestellt, dass ein Datensatz DS, der das zu orüfende bzw 6 zu wermessende Messobiekt 2 reoräsentiert. aus einer Speichereinrichtung ausgelesen werden kann. Hierbei können in der
- Fig. 1: ein schematisches Blockschaltbild einer erfindungsgemäßen Vorrichtung,
- Fig. 2: ein schematisches Flussdiagramm eines erfindungsgemäßen Verfahrens,
- Fig. 3: eine schematische Draufsicht auf ein Messobjekt,
- Fig. 4a: eine schematische Draufsicht auf ein Messobjekt,
- Fig. 4b: eine schematische Draufsicht auf ein Messobjekt,
- Fig. 4c: eine schematische Draufsicht auf ein Messobjekt,
- Fig. 5: eine perspektivische Ansicht eines Messobjekts,
- Fig. 6: eine schematische Draufsicht auf ein Messobjekt und
- Fig. 7: eine Detailansicht des in Fig. 6 dargestellten Messobjekts.

Speichereinrichtung Soll-Daten des Messobjekts 2, z.B. in Form von CAD-Daten, gespeichert sein.

Auch kann der Datensatz DS von einer Messeinrichtung 5, z.B. einer Koordinatenmessmaschine, erzeugt werden, wobei dieser derart erzeugte Datensatz DS (also der durch Vermessung erzeugte Datensatz DS) von der Vorrichtung 1 eingelesen wird.

Weiter dargestellt ist eine Speichereinrichtung 7 der Vorrichtung 1, in der für das Verfahren zur Erzeugung des Prüfplans notwendige Informationen gespeichert sein können.

Mittels der in Fig. 1 dargestellten Vorrichtung 1 ist das in Fig. 2 schematisch dargestellte Verfahren durchführbar.

In Fig. 2 ist ein schematisches Flussdiagramm eines erfindungsgemäßen Verfahrens zur Erzeugung eines Prüfplans für die Prüfung eines Messobjekts 2 (siehe Fig. 1) dargestellt. In einem ersten Schritt S1 wird ein das Messobjekt 2 repräsentierender Datensatz DS bereitgestellt. Diese Bereitstellung kann, wie vorhergehend erläutert, in Form des Soll-Datensatzes erfolgen, der beispielsweise aus einer Speichereinrichtung 6 ausgelesen werden kann. Alternativ kann dieser Datensatz durch Vermessung des Messobjekts 2, beispielsweise durch ein Koordinatenmessgerät 5, bereitgestellt werden.

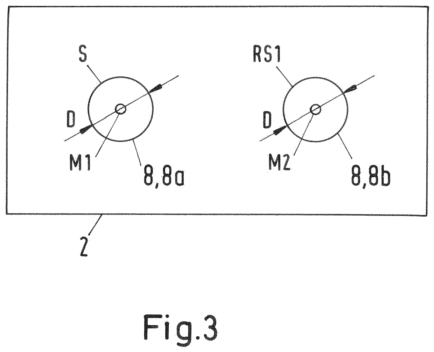

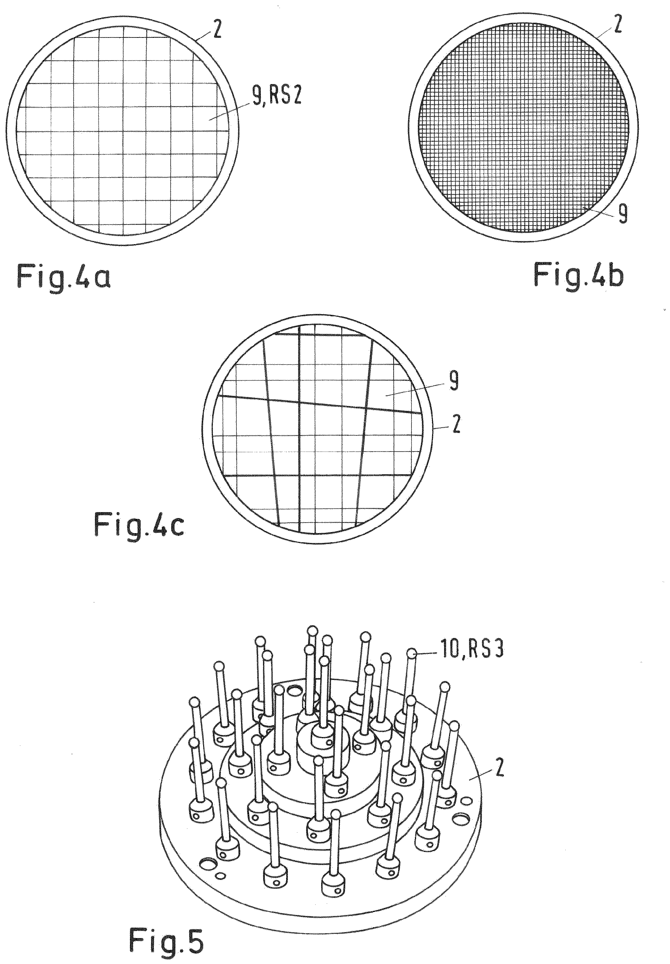

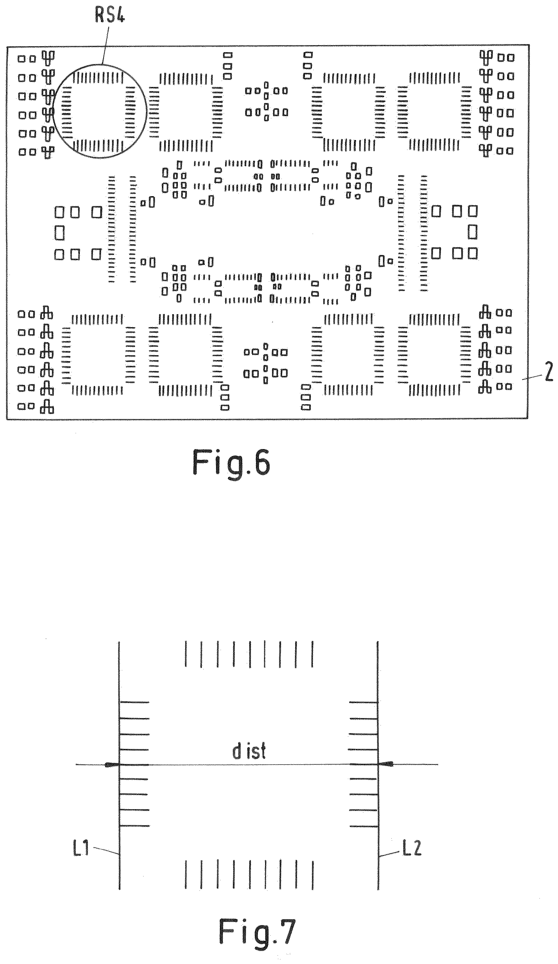

Auf Grundlage dieser Messdaten, also datenbasiert, wird in einem zweiten Schritt S2 eine Referenzstruktur festgelegt. Die Referenzstruktur kann beispielsweise eine kreisförmige Referenzstruktur RS1 (siehe Fig. 3), eine rechteckförmige Referenzstruktur RS2 (siehe Fig. 4a), eine kugelförmige Referenzstruktur RS3 (siehe Fig. 5) oder eine beliebig ausgebildete Referenzstruktur RS4 (siehe Fig. 6) sein.

Diese Referenzstruktur RS1, ..., RS4 kann z.B. durch eine Nutzereingabe festgelegt werden. Beispielweise kann ein Nutzer in einer Repräsentation des Datensatzes, z.B. einer grafischen Repräsentation wie einem Bild, einen Bereich von Interesse (ROI - Region of Interest) auswählen, der die Referenzstruktur umfasst oder bildet.

Alternativ ist es möglich, dass eine Referenzstruktur RS1,..., RS4 automatisch oder semi-automatisch bestimmt wird. Hierzu kann eine vorbekannte Zuordnung zwischen verschiedenen Referenzstrukturen und datenbasiert bestimmbaren Eigenschaften genutzt werden. Z.B. können verschiedene Teilmengen des Datensatzes untersucht und bestimmt werden, ob Eigenschaften der Teilmenge den Eigenschaften einer Referenzstruktur der Zuordnung entsprechen oder nicht mehr als ein vorbestimmtes Maß davon abweichen. Ist dies der Fall, so kann eine solche Teilmenge als Referenzstruktur RS1,...,RS4 bestimmt oder einem Nutzer zur Auswahl vorgeschlagen werden.

In einem dritten Schritt S3 wird der Referenzstruktur RS1,...,RS4 mindestens ein referenzstrukturspezifisches Prüfmerkmal zugeordnet. Dies kann z.B. erfolgen, indem der Referenzstruktur RS1, ..., RS4 mindestens ein Geometrieelement zugeordnet wird. Hierbei wird das referenzstrukturspezifische Prüfmerkmal auf Grundlage des mindestens einen Geometrieelements bestimmt. Alternativ kann der Referenzstruktur direkt ein Prüfmerkmal zugeordnet werden.

In Fig. 2 ist dargestellt, dass in einer Speichereinrichtung 7 z.B. vorbekannte Zuordnungen zwischen verschiedenen Referenzstrukturen RS1,..., RS4 und Prüfmerkmalen und/oder zwischen verschiedenen Referenzstrukturen RS1,..., RS4 und Geometrieelementen gespeichert sein können. Nach Festlegung der Referenzstruktur RS1,..., RS4 im zweiten Schritt S2 kann dann durch Auswertung der Zuordnungen bestimmt werden, ob die festgelegte Referenzstruktur einer Referenzstruktur RS1,..., RS4 dieser Zuordnung entspricht oder nicht mehr als ein vorbestimmtes Maß davon abweicht. Ist dies der Fall, so kann der Referenzstruktur RS1,..., RS4 das aus der Zuordnung bekannte Prüfmerkmal oder das Geometrieelement zugeordnet werden. Weiter kann auch eine Zuordnung zwischen einem Geometrieelement und dem Prüfmerkmal gespeichert sein, wobei dann der Referenzstruktur RS1,..., RS4 in Abhängigkeit der Zuordnung das entsprechende geometrieelementspezifische Prüfmerkmal zugeordnet wird.

In dem ersten Schritt S1 kann der Datensatz DS z.B. durch eine Messeinrichtung 5 aufgrund einer Vermessung des Messobjekts 2 bereitgestellt werden. Alternativ kann der Datensatz DS aus einer Speichereinrichtung 6 ausgelesen werden.

In einem fünften Schritt S5 wird für den das Messobjekt repräsentierende Datensatz DS datenbasiert geprüft, ob zur Referenzstruktur RS1,..., RS4 ähnliche oder gleiche Strukturen vorhanden sind. In einem sechsten Schritt S6 wird jeder ähnlichen oder gleichen Struktur das im dritten Schritt S3 für die Referenzstruktur RS1 ,..., RS4 bestimmte referenzstrukturspezifische Prüfmerkmal der detektierten ähnlichen oder gleichen Struktur zugeordnet. In einem siebten Schritt S7 wird der Prüfplan derart erzeugt, dass er die derart bestimmten strukturspezifischen Prüfmerkmale umfasst.

In einem erfindungsgemäßen Verfahren zur Prüfung eines Messobjekts 2 (siehe Fig. 1) kann ein solcher Prüfplan entsprechend einem Verfahren umfassend die Schritte S1 bis S7 erzeugt werden, wobei das Messobjekt 2 dann in einem nicht dargestellten achten Schritt gemäß dem Prüfplan geprüft werden kann.

In Fig. 3 ist schematisch ein Messobjekt 2 dargestellt, welches plattenförmig ausgebildet ist und rein beispielhaft zwei Öffnungen 8 aufweist. Diese Öffnungen 8 können z.B. als Durchgangsöffnungen oder sacklochartige Öffnungen ausgebildet sein. Eine erste Öffnung 8a weist einen ersten Mittelpunkt M1 auf. Eine zweite Öffnung 8b weist einen zweiten Mittelpunkt M2 auf. Das Messobjekt 2 ist hierbei in der Draufsicht rechteckförmig ausgebildet. Hierbei ist es möglich, dass z.B. die zweite Öffnung 8b eine Referenzstruktur RS1 bildet und als solche festgelegt wird. Dieser Referenzstruktur RS1 kann beispielsweise ein kreisförmiges Geometrieelement zugeordnet werden. Ein Prüfmerkmal kann ein Durchmesser D dieses kreisförmigen Geometrieelements sein.

Das Messobjekt 2 kann hierbei beispielsweise durch eine Bilderfassungseinrichtung abgebildet werden, wobei der das Messobjekt 2 repräsentierende Datensatz ein Bilddatensatz sein kann. In diesem Bilddatensatz kann dann datenbasiert, also insbesondere bildbasiert, untersucht werden, ob zur Referenzstruktur RS1 ähnliche oder gleiche Strukturen vorhanden sind. Beispielsweise können Bildeigenschaften der Referenzstruktur RS1 bestimmt werden, insbesondere eineindeutige Bildeigenschaften. Dann kann der Datensatz nach Teilmengen untersucht werden, die gleiche oder ähnliche Bildeigenschaften aufweisen. Hierbei kann z.B. die weitere Struktur S gefunden werden, die gleiche oder ähnliche Bildeigenschaften wie die Referenzstruktur RS1 aufweist. Dieser weiteren Struktur S, die der ersten Öffnung 8a entspricht, kann dann ebenfalls das Prüfmerkmal eines Durchmessers D zugeordnet werden.

Ein Prüfplan für das in Fig. 3 dargestellte Messobjekt 2 kann dann das der Referenzstruktur RS1 zugeordnete Prüfmerkmal des Durchmessers D und das der Struktur S, also der ersten Öffnung 8a, zugeordnete Prüfmerkmal eines Durchmessers D umfassen.

Weiter kann der Prüfplan auch Soll-Werte für den Durchmesser D umfassen. Weiter kann der Prüfplan auch zulässige Abweichungen von dem Soll-Durchmesser aufweisen. Weiter kann der Prüfplan dann auch ein Prüfkriterium umfassen, beispielsweise ob der festgestellte Durchmesser D nicht mehr als ein vorbestimmtes Maß von dem Soll-Durchmesser abweicht.

Fig. 4a zeigt eine schematische Draufsicht auf ein als Sieb ausgebildetes Messobjekt 2, welches eine Vielzahl von Maschen 9 aufweist. Der Übersichtlichkeit halber ist nur eine Masche 9 mit einem Bezugszeichen versehen. In einem solchen Fall kann datenbasiert als Referenzstruktur RS2 eine der Maschen 9 festgelegt werden. Dieser Masche 9 kann als Geometrieelement beispielsweise das Element Rechteck oder Quadrat zugeordnet werden. Als Prüfmerkmal kann der Referenzstruktur RS2 beispielsweise die Breite oder Höhe des Rechtecks oder Quadrats zugeordnet werden.

In Fig. 4b und Fig. 4c sind weitere als Sieb ausgebildete Messobjekte 2 dargestellt, deren Maschen 9, wie in dem in Fig. 4b dargestellten Beispiel, zwar der Referenzstruktur ähneln oder entsprechen, jedoch davon abweichende geometrische Dimensionen, also eine abweichende Breite oder eine abweichende Höhe, aufweisen. Je nach Abweichung der Höhe und/oder Breite kann dann eine solche Struktur nicht als zur Referenzstruktur ähnliche Struktur bestimmt werden, wobei einer solchen Struktur dann nicht das Prüfmerkmal der Referenzstruktur zugeordnet wird.

In Fig. 4c umfasst das als Sieb ausgebildete Messobjekt Maschen 9, die nicht der Referenzstruktur ähneln oder gleichen, da sie von der Soll-Geometrie eines Rechtecks oder Quadrats abweichen. Somit wird diesen abweichenden Maschen 9 auch nicht das Prüfmerkmal der Referenzstruktur zugeordnet.

Bei der Prüfung des Messobjekts 2 kann auch geprüft werden, ob die Anzahl der zur Referenzstruktur RS3 ähnlichen Strukturen von einer erwarteten, vorbekannten Anzahl abweicht oder ob die Anzahl von detektierten gleichen oder ähnlichen Strukturen außerhalb eines vorbekannten Bereichs zu erwartender ähnlicher oder gleicher Strukturen liegt. Ist dies der Fall so kann dies in das Prüfungsergebnis übernommen werden.

In Fig. 5 ist eine schematische perspektivische Ansicht eines als Abnahmenormals ausgebildeten Messobjekts 2 dargestellt, wobei dieses als Abnahmenormal für CT-Messgeräte dient. Dargestellt sind kugelförmige Normalenelemente 10, wobei eines dieser kugelförmigen Normalenelemente 10 als Referenzstruktur RS3 festgelegt werden kann. Diesem kugelförmigen Normalenelement 10 kann beispielsweise das Geometrieelement Kugel zugeordnet werden, wobei diesem dann als Prüfmerkmal ein Durchmesser zugeordnet werden kann.

Wird ein Abbild des Messobjekts 2, beispielsweise ein CT-basiertes Abbild, generiert, so können alle dargestellten kugelförmigen Normalenelemente in dem Abbild als zur Referenzstruktur RS3 gleiche oder ähnliche Strukturen erkannt werden und dann können diesen das erläuterte Prüfmerkmal jeweils zugeordnet werden. Dies vereinfacht die Erzeugung des Prüfplans für das dargestellte Abnahmenormal.

In Fig. 6 ist eine schematische Draufsicht auf ein als Leiterplatte ausgebildetes Messobjekt 2 dargestellt. Ein dieses Messobjekt 2 repräsentierender Datensatz DS kann beispielsweise mittels einer Bilderfassungseinrichtung erzeugt werden, also als Bilddatensatz. Dargestellt ist, dass auf der Leiterplatte gleichartige Strukturen angeordnet sind, die im Wesentlichen rechteckförmig ausgebildet sind. Im dargestellten Ausführungsbeispiel sind diese Strukturen die Abbildungen von Lötflächen von Computerchips. Hierbei wird eine der Strukturen als Referenzstruktur RS4 festgelegt.

In Fig. 7 ist eine Detailansicht dieser Referenzstruktur RS4 dargestellt. Weiter dargestellt ist, dass dieser Referenzstruktur RS4 als Geometrieelemente zwei Linien L1, L2 zugeordnet werden, wobei der Referenzstruktur RS4 dann als Prüfmerkmal eine Distanz dist zwischen den Linien zugeordnet wird. Diese Distanz dist kann beispielsweise mittels einem dem Fachmann bekannten Verfahren zur Bestimmung einer Distanz dist zwischen zwei Linien L1, L2 bestimmt werden.

In dem Bilddatensatz, welcher das in Fig. 6 dargestellte und als Leiterplatte ausgebildete Messobjekt 2 repräsentiert, kann dann bildbasiert nach ähnlichen oder gleichen Strukturen gesucht werden, wobei diesen ähnlichen oder gleichen Strukturen, im vorliegenden Ausführungsbeispiel also sieben weiteren Strukturen, das erläuterte Prüfmerkmal der Distanz dist zwischen zwei Linien L1, L2 zugeordnet wird. Bei der Prüfung werden also für jede dieser Strukturen die entsprechenden Linien L1, L2 und dann deren Distanz dist bestimmt.

### Bezugszeichenliste

- 1: Vorrichtung
- 2: Messobjekt
- 3: Schnittstelle
- 4: Auswerteeinrichtung
- 5: Messeinrichtung
- 6: Speichereinrichtung
- 7: Speichereinrichtung
- 8: Öffnung
- 8a: erste Öffnung
- 8b: zweite Öffnung
- 9: Masche
- 10: kugelförmiges Geometrieelement
- RS1: erste Referenzstruktur
- RS2: zweite Referenzstruktur
- RS3: dritte Referenzstruktur
- RS4: vierte Referenzstruktur
- M1: erster Mittelpunkt
- M2: zweiter Mittelpunkt
- S: Struktur
- S1: erster Schritt
- S2: zweiter Schritt
- S3: dritter Schritt
- S4: vierter Schritt
- S5: fünfter Schritt
- S6: sechster Schritt
- S7: siebter Schritt
- D: Durchmesser

## Patentansprüche

1. Verfahren zur Erzeugung eines Prüfplans für die Prüfung eines Messobjekts (2) durch ein Prüf- oder Messgerät, wobei ein das Messobjekt (2) repräsentierender Datensatz (DS) bereitgestellt wird, wobei folgende computerimplementierte Schritte durchgeführt werden:
• datenbasierte Festlegung einer Referenzstruktur (RS1, RS2, RS3, RS4),
• Zuordnen mindestens eines referenzstrukturspezifischen Prüfmerkmals zu der Referenzstruktur (RS1, RS2, RS3, RS4),
**dadurch gekennzeichnet, dass** das Verfahren zusätzlich folgende computerimplementierte Schritte umfasst:
• datenbasierte Prüfung für den das Messobjekt (2) repräsentierenden Datensatz (DS), ob zur Referenzstruktur (RS1, RS2, RS3, RS4) ähnliche oder gleiche Strukturen (S) vorhanden sind, wobei jeder ähnlichen oder gleichen Struktur (S) das referenzstrukturspezifische Prüfmerkmal als strukturspezifisches Prüfmerkmal zugeordnet wird,
wobei der Prüfplan die derart bestimmten strukturspezifischen Prüfmerkmale umfasst.

2. Verfahren nach Anspruch 1, **dadurch gekennzeichnet, dass** der Referenzstruktur (RS1, RS2, RS3, RS4) mindestens ein Geometrieelement zugeordnet wird, wobei das referenzstrukturspezifische Prüfmerkmal auf Grundlage des mindestens einen Geometrieelements bestimmt wird.

3. Verfahren nach Anspruch 1 oder 2, **dadurch gekennzeichnet, dass** der das Messobjekt (2) repräsentierende Datensatz (DS) durch eine Vermessung des jeweiligen Messobjekts (2) erzeugt wird oder ein Soll-Datensatz ist.

4. Verfahren nach einem der vorangegangenen Ansprüche, **dadurch gekennzeichnet, dass** für einen weiteren Datensatz (DS), der das Messobjekt (2) oder ein weiteres Messobjekt repräsentiert, datenbasiert geprüft wird, ob zur Referenzstruktur (RS1, RS2, RS3, RS4) ähnliche oder gleiche Strukturen vorhanden sind, wobei jeder ähnlichen oder gleichen Struktur (S) das referenzstrukturspezifische Prüfmerkmal zugeordnet wird,
wobei der Prüfplan die derart bestimmten Prüfmerkmale umfasst.

5. Verfahren nach Anspruch 4, **dadurch gekennzeichnet, dass** der weitere Datensatz durch eine Vermessung des Messobjekts (2) oder eines gleichartigen Messobjekts erzeugt wird.

6. Verfahren nach Anspruch 4 oder 5, **dadurch gekennzeichnet, dass** bei der datenbasierten Prüfung, ob zur Referenzstruktur (RS1, RS2, RS3, RS4) ähnliche oder gleiche Strukturen (S) im weiteren Datensatz vorhanden sind, vorbekannte oder vorhergehend bestimmte strukturspezifische Positionsinformationen und/oder Orientierungsinformationen berücksichtigt werden.

7. Verfahren nach einem der vorangegangenen Ansprüche, **dadurch gekennzeichnet, dass** ein das Messobjekt (2) repräsentierender Datensatz (DS) ein dreidimensionaler Datensatz oder ein zweidimensionaler Datensatz ist.

8. Verfahren nach einem der vorangegangenen Ansprüche, **dadurch gekennzeichnet, dass** der Datensatz (DS) ein Bilddatensatz ist.

9. Verfahren nach einem der vorangegangenen Ansprüche, **dadurch gekennzeichnet, dass** der Referenzstruktur (RS1, RS2, RS3, RS4) ein Prüfmerkmal in Abhängigkeit einer vorbekannten Zuordnung zugeordnet wird und/oder dass der Referenzstruktur (RS1, RS2, RS3, RS4) ein Geometrieelement in Abhängigkeit einer vorbekannten Zuordnung zugeordnet wird.

10. Verfahren nach einem der vorangegangenen Ansprüche, **dadurch gekennzeichnet, dass** ein Kriterium zur Bestimmung der Ähnlichkeit von Strukturen (S) in einem Soll-Datensatz (DS) schärfer ist als ein Kriterium zur Bestimmung der Ähnlichkeit von Strukturen (S) in einem durch Vermessung erzeugten Datensatz (DS).

11. Verfahren nach einem der vorangegangenen Ansprüche, **dadurch gekennzeichnet, dass** das Verfahren als Simulation durchgeführt wird.

12. Programm, welches, wenn es auf oder durch einen Computer ausgeführt wird, den Computer veranlasst, alle computerimplementierten Schritte des Verfahrens zur Erzeugung eines Prüfplans für die Prüfung eines Messobjekts (2) gemäß einem der Ansprüche 1 bis 11 durchzuführen.

13. Vorrichtung zur Erzeugung eines Prüfplans für die Prüfung eines Messobjekts (2) durch ein Prüf- oder Messgerät, wobei die Vorrichtung (1) mindestens eine Schnittstelle (3) zum Einlesen eines Datensatzes (DS) und mindestens eine Auswerteeinrichtung (4) umfasst, wobei ein das Messobjekt (2) repräsentierender Datensatz (DS) über die Schnittstelle (3) einlesbar ist, wobei datenbasiert eine Referenzstruktur (RS1, RS2, RS3, RS4) durch die Auswerteeinrichtung (4) festlegbar ist, wobei der Referenzstruktur (RS1, RS2, RS3, RS4) mindestens ein referenzstrukturspezifisches Prüfmerkmal zuordenbar ist,
**dadurch gekennzeichnet, dass**
für den das Messobjekt (2) repräsentierenden Datensatz (DS) datenbasiert durch die Auswerteeinrichtung (4) prüfbar ist, ob zur Referenzstruktur (RS1, RS2, RS3, RS4) ähnliche oder gleiche Strukturen (S) vorhanden sind, wobei jeder ähnlichen oder gleichen Struktur (S) das referenzstrukturspezifische Prüfmerkmal als strukturspezifisches Prüfmerkmal zuordenbar sind,
wobei der Prüfplan die derart bestimmten strukturspezifischen Prüfmerkmale umfasst.

14. Verfahren zur Prüfung eines Messobjekts, wobei ein Prüfplan mit einem Verfahren gemäß einem der Ansprüche 1 bis 11 erzeugt wird, wobei das Messobjekt (2) gemäß dem Prüfplan geprüft wird.

15. Vorrichtung zur Prüfung eines Messobjekts (2) gemäß dem Anspruch 13, wobei die Vorrichtung eine Vorrichtung zur Erzeugung eines Prüfplans für die Prüfung des Messobjekts (2) umfasst, wobei ein Prüfplan mit einem Verfahren gemäß einem der Ansprüche 1 bis 11 erzeugbar ist, wobei die Vorrichtung mindestens eine Steuereinrichtung zur Durchführung des Prüfplans umfasst, wobei das Messobjekt gemäß dem Prüfplan prüfbar ist.

## Claims

1. Method for generating a test plan for the testing of a measurement object (2) by a test or measuring device, wherein a data set (DS) representing the measurement object (2) is provided, wherein the following computer-implemented steps are carried out:
• data-based definition of a reference structure (RS1, RS2, RS3, RS4),
• assigning at least one reference-structure-specific test feature to the reference structure (RS1, RS2, RS3, RS4),
**characterized in that** the method additionally comprises the following computer-implemented steps:
• data-based testing for the data set (DS) representing the measurement object (2) to establish whether structures (S) similar or identical to the reference structure (RS1, RS2, RS3, RS4) are present, wherein the reference-structure-specific test feature is assigned to each similar or identical structure (S) as a structure-specific test feature,
wherein the test plan comprises the structure-specific test features determined in this way.

2. Method according to Claim 1, **characterized in that** at least one geometric element is assigned to the reference structure (RS1, RS2, RS3, RS4), wherein the reference-structure-specific test feature is determined on the basis of the at least one geometric element.

3. Method according to Claim 1 or 2, **characterized in that** the data set (DS) representing the measurement object (2) is generated by a measurement of the respective measurement object (2) or is a target data set.

4. Method according to any of the preceding claims, **characterized in that** for a further data set (DS) representing the measurement object (2) or a further measurement object, data-based testing is effected to establish whether structures similar or identical to the reference structure (RS1, RS2, RS3, RS4) are present, wherein the reference-structure-specific test feature is assigned to each similar or identical structure (S),
wherein the test plan comprises the test features determined in this way.

5. Method according to Claim 4, **characterized in that** the further data set is generated by a measurement of the measurement object (2) or of a measurement object of identical type.

6. Method according to Claim 4 or 5, **characterized in that** previously known or previously determined structure-specific position information items and/or orientation information items are taken into account during the data-based testing to establish whether structures (S) similar or identical to the reference structure (RS1, RS2, RS3, RS4) are present in the further data set.

7. Method according to any of the preceding claims, **characterized in that** a data set (DS) representing the measurement object (2) is a three-dimensional data set or a two-dimensional data set.

8. Method according to any of the preceding claims, **characterized in that** the data set (DS) is an image data set.

9. Method according to any of the preceding claims, **characterized in that** a test feature is assigned to the reference structure (RS1, RS2, RS3, RS4) depending on a previously known assignment, and/or in that a geometric element is assigned to the reference structure (RS1, RS2, RS3, RS4) depending on a previously known assignment.

10. Method according to any of the preceding claims, **characterized in that** a criterion for determining the similarity of structures (S) in a target data set (DS) is more stringent than a criterion for determining the similarity of structures (S) in a data set (DS) generated by measurement.

11. Method according to any of the preceding claims, **characterized in that** the method is carried out as a simulation.

12. Program which, when it is executed on or by a computer, causes the computer to carry out all the computer-implemented steps of the method for generating a test plan for the testing of a measurement object (2) according to any of Claims 1 to 11.

13. Apparatus for generating a test plan for the testing of a measurement object (2) by a test or measuring device, wherein the apparatus (1) comprises at least one interface (3) for reading in a data set (DS), and at least one evaluation device (4), wherein a data set (DS) representing the measurement object (2) is able to be read in via the interface (3), wherein a reference structure (RS1, RS2, RS3, RS4) is definable in a data-based manner by the evaluation device (4), wherein at least one reference-structure-specific test feature is assignable to the reference structure (RS1, RS2, RS3, RS4),
**characterized in that**
for the data set (DS) representing the measurement object (2), data-based testing is able to be effected by the evaluation device (4) to establish whether structures (S) similar or identical to the reference structure (RS1, RS2, RS3, RS4) are present, wherein the reference-structure-specific test feature is assignable as a structure-specific test feature to each similar or identical structure (S),
wherein the test plan comprises the structure-specific test features determined in this way.

14. Method for testing a measurement object, wherein a test plan is generated by a method according to any of Claims 1 to 11, wherein the measurement object (2) is tested in accordance with the test plan.

15. Apparatus for testing a measurement object (2) according to Claim 13, wherein the apparatus comprises an apparatus for generating a test plan for the testing of the measurement object (2), wherein a test plan is generable by a method according to any of Claims 1 to 11, wherein the apparatus comprises at least one control device for carrying out the test plan, wherein the measurement object is testable in accordance with the test plan.

## Revendications

1. Procédé pour générer un plan de contrôle pour le contrôle d'un objet de mesure (2) par un appareil de contrôle ou de mesure, un jeu de données (DS) représentant l'objet de mesure (2) étant fourni, les étapes mises en œuvre par ordinateur suivantes étant exécutées :
* spécification basée sur les données d'une structure de référence (RS1, RS2, RS3, RS4),
* association à la structure de référence (RS1, RS2, RS3, RS4) d'au moins une caractéristique de contrôle spécifique à la structure de référence,
**caractérisé en ce que** le procédé comprend en outre les étapes mises en œuvre par ordinateur suivantes :
* contrôle basé sur les données pour le jeu de données (DS) représentant l'objet de mesure (2) afin de vérifier si des structures (S) similaires ou identiques à la structure de référence (RS1, RS2, RS3, RS4) sont présentes, la caractéristique de contrôle spécifique à la structure de référence étant associée à chaque structure (S) similaire ou identique en tant que caractéristique de contrôle spécifique à la structure, le plan de contrôle comprenant les caractéristiques de contrôle spécifiques à la structure ainsi déterminées.

2. Procédé selon la revendication 1, **caractérisé en ce qu'**au moins un élément géométrique est associé à la structure de référence (RS1, RS2, RS3, RS4), la caractéristique de contrôle spécifique à la structure de référence étant déterminée sur la base de l'au moins un élément géométrique.

3. Procédé selon la revendication 1 ou 2, **caractérisé en ce que** le jeu de données (DS) représentant l'objet de mesure (2) est généré par une mesure de l'objet de mesure (2) respectif ou est un jeu de données de consigne.

4. Procédé selon l'une des revendications précédentes, **caractérisé en ce que** pour un jeu de données (DS) supplémentaire, qui représente l'objet de mesure (2) ou un objet de mesure supplémentaire, un contrôle est effectué sur la base des données afin de vérifier si des structures similaires ou identiques à la structure de référence (RS1, RS2, RS3, RS4) sont présentes, la caractéristique de contrôle spécifique à la structure de référence étant associée à chaque structure (S) similaire ou identique, le plan de contrôle comprenant les caractéristiques de contrôle ainsi déterminées.

5. Procédé selon la revendication 4, **caractérisé en ce que** le jeu de données supplémentaire est généré par une mesure de l'objet de mesure (2) ou d'un objet de mesure de même type.

6. Procédé selon la revendication 4 ou 5, **caractérisé en ce que** lors du contrôle basé sur les données en vue de vérifier si des structures (S) similaires ou identiques à la structure de référence (RS1, RS2, RS3, RS4) sont présentes dans le jeu de données supplémentaire, des informations de position et/ou des informations d'orientation spécifiques à la structure préalablement connues ou déterminées précédemment sont prises en compte.

7. Procédé selon l'une des revendications précédentes, **caractérisé en ce qu'**un jeu de données (DS) représentant l'objet de mesure (2) est un jeu de données tridimensionnel ou un jeu de données bidimensionnel.

8. Procédé selon l'une des revendications précédentes, **caractérisé en ce que** le jeu de données (DS) est un jeu de données d'image.

9. Procédé selon l'une des revendications précédentes, **caractérisé en ce qu'**une caractéristique de contrôle est associée à la structure de référence (RS1, RS2, RS3, RS4) en fonction d'une association préalablement connue et/ou **en ce qu'**un élément géométrique est associé à la structure de référence (RS1, RS2, RS3, RS4) en fonction d'une association préalablement connue.

10. Procédé selon l'une des revendications précédentes, **caractérisé en ce qu'**un critère destiné à déterminer la similitude de structures (S) dans un jeu de données de consigne (DS) est plus sévère qu'un critère destiné à déterminer la similitude de structures (S) dans un jeu de données (DS) généré par mesure.

11. Procédé selon l'une des revendications précédentes, **caractérisé en ce que** le procédé est mis en œuvre en tant que simulation.

12. Programme qui, lorsqu'il est exécuté sur un ordinateur, amène l'ordinateur à exécuter toutes les étapes mises en œuvre par ordinateur du procédé pour générer un plan de contrôle pour le contrôle d'un objet de mesure (2) selon l'une des revendications 1 à 11.

13. Arrangement pour générer un plan de contrôle pour le contrôle d'un objet de mesure (2) par un appareil de contrôle ou de mesure, l'arrangement (1) comportant au moins une interface (3) servant à la lecture d'un jeu de données (DS) et au moins un dispositif d'interprétation (4), un jeu de données (DS) représentant l'objet de mesure (2) pouvant être lu par le biais de l'interface (3), une structure de référence (RS1, RS2, RS3, RS4) pouvant être spécifiée par le dispositif d'interprétation (4) en se basant sur les données, au moins une caractéristique de contrôle spécifique à la structure de référence pouvant être associée à la structure de référence (RS1, RS2, RS3, RS4),
**caractérisé en ce que**
pour le jeu de données (DS) représentant l'objet de mesure (2), il est possible de vérifier, en se basant sur les données, par le dispositif d'interprétation (4), si des structures (S) similaires ou identiques à la structure de référence (RS1, RS2, RS3, RS4) sont présentes, la caractéristique de contrôle spécifique à la structure de référence pouvant être associée à chaque structure (S) similaire ou identique en tant que caractéristique de contrôle spécifique à la structure, le plan de contrôle comprenant les caractéristiques de contrôle spécifiques à la structure ainsi déterminées.

14. Procédé de contrôle d'un objet de mesure, un plan de contrôle étant généré avec un procédé selon l'une des revendications 1 à 11, l'objet de mesure (2) étant contrôlé conformément au plan de contrôle.

15. Arrangement de contrôle d'un objet de mesure (2) selon la revendication 13, l'arrangement comprenant un arrangement destiné à générer un plan de contrôle pour le contrôle de l'objet de mesure (2), un plan de contrôle pouvant être généré avec un procédé selon l'une des revendications 1 à 11, l'arrangement comprenant au moins un dispositif de commande destiné à exécuter le plan de contrôle, l'objet de mesure pouvant être contrôlé conformément au plan de contrôle.
